## Europäisches Patentamt
## European Patent Office
## Office européen des brevets

(19)

(11) Veröffentlichungsnummer: **0 080 740**

**A2**

(12) # EUROPÄISCHE PATENTANMELDUNG

(21) Anmeldenummer: **82112073.0**

(22) Anmeldetag: **02.10.80**

(51) Int. Cl.³: **H 03 K 17/687**

(30) Priorität: **09.10.79 DE 2940954**

(43) Veröffentlichungstag der Anmeldung:
**08.06.83 Patentblatt 83/23**

(84) Benannte Vertragsstaaten:
**BE CH DE FR GB IT LI NL SE**

(60) Veröffentlichungsnummer der früheren
Anmeldung nach Art. 76 EPÜ: **0 027 919**

(71) Anmelder: **Nixdorf Computer Aktiengesellschaft**
**Fürstenallee 7**
**D-4790 Paderborn(DE)**

(72) Erfinder: **Höfflinger, Bernd, Prof. Dr.**
**Gartenstrasse 23**
**D-4600 Dortmund 30(DE)**

(72) Erfinder: **Zimmer, Günther, Dr.**
**Am Kornfeld 22**
**D-4600 Dortmund 30(DE)**

(72) Erfinder: **Habekotte, Ernst**
**Ruthstrasse 8/2**
**D-4600 Dortmund 76(DE)**

(72) Erfinder: **Renker, Wolfgang**
**Froschlake 43**
**D-4600 Dortmund 70(DE)**

(74) Vertreter: **Patentanwälte Schaumburg, Schulz-Dörlam**
**& Thoenes**
**Mauerkircherstrasse 31**
**D-8000 München 80(DE)**

(54) **Schaltungsanordnung zum Schalten von Leistungsstromkreisen unter Verwendung von Hochspannungs-MOS-Transistoren.**

(57) Eine Schaltungsanordnung zum Schalten von Leistungsstromkreisen unter Verwendung von Hochspannungs-MOS-Transistoren enthält einen mit seiner gesteuerten Strecke in Reihe zu einer Ausgangslast (beispielsweise 114) liegenden Hochspannungs-MOS-Schalttransistor (beispielsweise 110), eine an der Reihenschaltung aus gesteuerter Strecke des Schalttransistors (beispielsweise 110) und Ausgangslast (beispielweise 114) liegende zu schaltende Spannung (V) und einen an dieser Spannung liegenden kapazitiven Spannungsteiler (beispielsweise 111, 112), an dessen Abgriff das Gate des Schalttransistors (beispielsweise 110) liegt.

FIG 3

EP 0 080 740 A2

Croydon Printing Company Ltd

Schaltungsanordnung zum Schalten von Leistungsstromkreisen unter Verwendung von Hochspannungs-MOS-
Transistoren

---

Die vorliegende Erfindung betrifft eine Schaltungsanordnung nach dem Oberbegriff des Patentanspruchs 1.

Es ist aus der Zeitschrift "IEEE Journal of Solid-State
Circuits", Vol. SC-11, Nr. 6, Dezember 1976, Seiten 809
bis 816 bekannt, Hochspannungs-MOS-Transistoren dadurch
herzustellen, daß auf ein schwachdotiertes Halbleitersubstrat eines Leitungstyps zunächst eine schwachdotierte Schicht des anderen Leitungstyps epitaktisch abgeschieden wird und daß sodann in einem Doppeldiffusionsschritt
durch ein einziges Fenster in einer auf der epitaktischen
Schicht befindlichen maskierenden Oxidschicht zunächst
eine Zone mit gegenüber der epitaktischen Schicht entgegengesetztem Leitungstyp und sodann in diese Zone eine
hochdotierte Zone mit dem Leitungstyp der epitaktischen
Schicht eingebracht wird. Flächenmäßig versetzt gegen die
erstgenannte Zone mit gegenüber der epitaktischen Schicht
entgegengesetztem Leitungstyp wird durch ein weiteres
in der genannten Oxidschicht auf der epitaktischen Schicht
vorgesehenes Fenster eine dritte hochdotierte Zone eingebracht, welche den selben Leitungstyp wie die epitaktische Schicht besitzt.

In Lateralrichtung entsteht somit in der epitaktischen
Schicht ein MOS-Transistor, bei dem durch gemeinsame
Kontaktierung der beiden erstgenannten Zonen an einer
Seite die Source, durch den dem Sourcekontakt abgewandten
Bereich der Zone mit gegenüber der epitaktischen Schicht
entgegengesetztem Leitungstyp der Kanal, auf dem durch ein Dünnoxid getrennt eine Gateelektrode vorgesehen ist, und durch die dritte hochdotierte Zone mit dem Leitungstyp der epitaktischen Schicht und einem entsprechenden Kontakt die Drain gebildet wird. Der Kanal eines solchen Transistors ist von der Drain durch einen hochohmigen Bereich der epitaktischen Schicht getrennt, welche eine Driftzone bildet.

In einer integrierten Schaltung muß ein Transistor der vorstehend beschriebenen Art von weiteren in der epitaktischen Schicht vorgesehenen Funktionseinheiten allseitig durch einen Isolationsrahmen getrennt werden, welcher durch eine Isolationsdiffusion gebildet wird, die durch die epitaktische Schicht bis in das Substrat durchgreift und den Leitungstyp des Substrats besitzt.

Aufgrund des genannten Isolationsrahmens ergibt sich für eine integrierte Schaltung ein hoher Flächenbedarf, so daß die erreichbare Integrationsdichte entsprechend niedrig wird.

Darüber hinaus ist durch die epitaktische Schicht die Prozeßlinie festgelegt, so daß ohne zusätzlichen Aufwand an Prozeßschritten, je nach Leitungstyp der epitaktischen Schicht, nur n-Kanal- oder p-Kanal-Transistoren herstellbar sind. Zur Realisierung von komplementären Transistoren, d.h., einer integrierten Schaltung in CMOS-Technologie, werden zu den vorstehend beschriebenen Transistoren komplementäre Transistoren durch zwei in Serie geschaltete Transistoren mit einer floatenden Zwischendrain realisiert. Abgesehen von dem durch die Isolationsdiffusion bedingten hohen Platzbedarf ergibt sich bei solchen Transistoren ein noch höherer Platzbedarf aufgrund der für die floatende Zwischendrain erforderlichen zusätzlichen Zone. Darüber hinaus wird die Gesamtkanallänge aufgrund der Hintereinanderschaltung zweier Transistoren und damit zweier Kanäle relativ groß, was noch einmal zu einem erhöhten Flächenbedarf beiträgt. Da bei MOS-Transistoren die Verstärkung proportional zum Verhältnis von Kanalweite zu Kanallänge (W/L-Verhältnis) ist, ist die Verstärkung solcher Transistoren aufgrund der relativ großen Gesamtkanallänge entsprechend gering.

Es wurde ein Verfahren zur Herstellung von Hochspannungs-MOS-Transistoren enthaltenden MOS-integrierten Schaltkreisen entwickelt, nach dem Hochspannungs-MOS-Transistoren mit geringem Prozeßaufwand und geringem Flächenbedarf bei gleichzeitig größtmöglicher Freiheit hinsichtlich der Wahl der Transistor-Parameter herstellbar sind. Insbesondere ermöglicht es das Verfahren auch, komplementäre Transistoren dieser Art, d.h., CMOS-Schaltkreise ohne wesentlichen zusätzlichen Prozeßaufwand herzustellen.

Dieses Verfahren ist derart ausgebildet, daß die die Driftzonen enthaltenden Zonen in einem einzigen Dotierungsschritt mit einer solchen Abmessung hergestellt werden, daß sie mindestens die Drain der Hochspannungs-MOS-Transistoren allseitig umgeben.

Das Verfahren gestattet es, die die Driftzonen für Hochspannungs-MOS-Transistoren enthaltenden Zonen wahlfrei durch einen einzigen selektiven Dotierungsprozeß dort in einem Halbleitersubstrat vorzusehen, wo sie für die Funktionseinheiten von MOS-integrierten Schaltkreisen erforderlich sind. Im Gegensatz zu einer ganzflächig auf einem Halbleitersubstrat aufgebrachten epitaktischen Schicht, welche notwendigerweise den Leitungstyp als Ausgangspunkt für die gesamte Prozeßtechnologie einer integrierten Schaltung festlegt, gewährleisten die nach dem Verfahren hergestellten, die Driftzonen für Hochspannungs-MOS-Transistoren enthaltenden Zonen einen weit
größeren Freiheitsgrad für nachfolgende Prozesse zur
Herstellung von Funktionseinheiten unterschiedlicher
Art in MOS-integrierten Schaltkreisen.

Es können zusätzlich Hochspannungs-MOS-Transistoren hergestellt werden,bei denen die die Driftzonen enthaltenden Zonen die Transistoren allseitig umgebend ausgebildet werden.

Während bei einem Hochspannungs-MOS-Transistor, bei dem
die die Driftzone enthaltende Zone lediglich die Drain
umgibt, der Vorteil erzielt wird, daß diese Zone beim
Anlegen der Drain-Source-Spannung als sogenannter Pinch-
Widerstand wirkt und damit der Durchbruch des Hochspannungs-
MOS-Transistors erst bei höheren Spannungen eintritt, ergibt sich bei einem allseitig von der die Driftzone enthaltenden Zone umgebenen Transistor der Vorteil einer
höheren Verstärkung, so daß die erzielbare Leistung für
beide Transistoren etwa gleich ist.

Zur Herstellung von zu den vorstehend beschriebenen Hochspannungs-MOS-Transistoren komplementären Hochspannungs-
MOS-Transistoren ist es möglich,daß in den Zonen mit gegenüber dem Leitungstyp des Halbleitersubstrats entgegengesetztem Leitungstyp Driftzonen enthaltende, die
Drain allseitig umgebende Zonen ausgebildet werden.

Es ist dabei möglich, die Zonen mit gegenüber dem Leitungstyp des Halbleitersubstrats entgegengesetztem Leitungstyp zur Herstellung von komplementären Hochspannungs-
MOS-Transistoren durch einen einzigen Dotierungsprozeß,
insbesondere einen Implantationsprozeß und einen Nachdiffusionsprozeß auszubilden und lediglich durch einen einzigen weiteren Prozeßschritt die die Driftzonen für komplementäre Hochspannungs-MOS-Transistoren enthaltenden Zonen durch einen Dotierungsprozeß mit einer solchen Dotierungskonzentration auszubilden, daß sie dem des Substrats entsprechenden Leitungstyp haben und höchstens gleich stark wie die sie enthaltenden Zonen dotiert sind. Die die Driftzonen für komplementäre Hochspannungs-MOS-Transistoren enthaltenden Zonen werden dabei vorteilhaft durch einen vorzugsweise durch ein Oberflächenoxid hindurchgeführten Implantationsprozeß und einen Nachdiffusionsprozeß ausgebildet.

Es ist Aufgabe der Erfindung, eine Schaltungsanordnung anzugeben, die einen Einsatz von Hochspannungs-MOS-Transistoren zum Schalten von Leistungstromkreisen so vorsieht, daß eine geringe Schaltverlustleistung entsteht und eine Nutzung der Vorteile integrierter Anordnungen möglich ist, die nach dem vorstehend beschriebenen Verfahren hergestellt sind.

Eine Schaltungsanordnung eingangs genannter Art ist zur Lösung dieser Aufgabe erfindungsgemäß gekennzeichnet durch einen mit seiner gesteuerten Strecke in Reihe zu einer Ausgangslast liegenden Hochspannungs-MOS-Schalttransistor, eine an der Reihenschaltung aus gesteuerter Strecke des Schalttransistors und Ausgangslast liegende zu schaltende pulsierende Spannung und einen an dieser Spannung liegenden kapazitiven Spannungsteiler, an dessen Abgriff das Gate des Schalttransistors liegt.

Durch die zu schaltende pulsierende Spannung wird bei einer Schaltungsanordnung der vorstehend definierten Art der Vorteil erzielt, daß während des Schaltens am dann durchgeschalteten Schalttransistor ein kleinerer Spannungsabfall und damit eine kleinere Verlustleistung im Vergleich zu Schaltungsanordnungen mit einer statischen Schaltspannung auftritt. Darüber hinaus kann bei der erfindungsgemäßen Schaltungsanordnung die Spannung an einer Ausgangslast der fallenden Flanke der Schaltspannung über den Schalttransistor folgen, während bei statischer Schaltspannung hierzu ein zusätzlicher Transistor erforderlich ist. Zum Schalten von Wechsel-Leistungskreisen kann die Schaltungsanordnung als Gegentaktschaltung mit zwei in Reihe an einer zu schaltenden Wechselspannung und jeweils in Reihe zu einer einzigen Ausgangslast liegenden komplementären Hochspannungs-MOS-Schalttransistoren und mit jeweils einem an der zu schaltenden Wechselspannung liegenden kapazitiven Spannungsteiler, an dessen Abgriff jeweils das Gate eines Schalttransistors liegt, ausgebildet werden.

Um den Einsatzpunkt des oder der Schalttransistoren variabel ausgestalten zu können, kann ein von einem Taktsignal gesteuerter Hochspannungs-MOS-Steuertransistor vorgesehen werden, über den eine Steuerspannung als Funktion des Taktsignals an das Gate des oder der Schalttransistoren koppelbar ist. Die Steuerspannung kann dabei solche Polarität besitzen, daß die durch Überlagerung der Steuerspannung und der durch die zu schaltende Spannung über den kapazitiven Spannungsteiler erzeugten effektiven Gatespannung gegenüber der durch die zu schaltende Spannung über den kapazitiven Spannungsteiler allein erzeugten Gatespannung entweder erniedrigt oder erhöht wird.

Die Erfindung wird im folgenden anhand von in den Figuren der Zeichnung dargestellen Ausführungsbeispielen näher erläutert. Es zeigt:

Figur 1   einen MOS-integrierten Schaltkreis;

Figur 2 eine Ausführungsform einer Schaltungsanordnung zum Schalten von Wechsel-Leistungskreisen;

Figur 3 eine Ausführungsform einer Schaltungsanordnung
zum Schalten einer pulsierenden Spannung einer
Polarität mit einem zusätzlich zu einem Hochspannungs-MOS-Schalttransistor vorgesehenen,
durch ein Taktsignal gesteuerten Hochspannungs-
MOS-Steuertransistor zur Einkopplung einer
Steuerspannung als Funktion des Taktsignals
an das Gate des Schalttransistors;

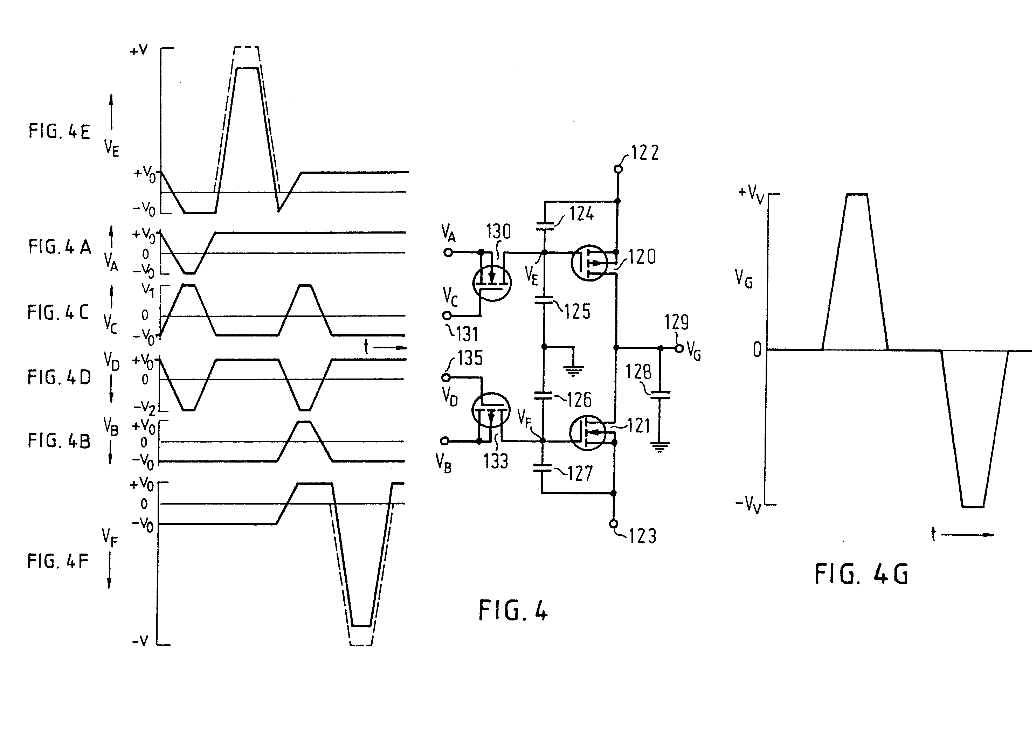

Figur 4 eine Ausführungsform einer Schaltungsanordnung
zum Schalten von Wechsel-Leistungskreisen in
Form einer Gegentaktschaltung mit über Hochspannungs-MOS-Steuertransistoren eingespeisten
Steuerspannungen, welche derart gewählt sind,
daß die zu schaltende Wechselspannung mit großer
Amplitude geschaltet wird; und

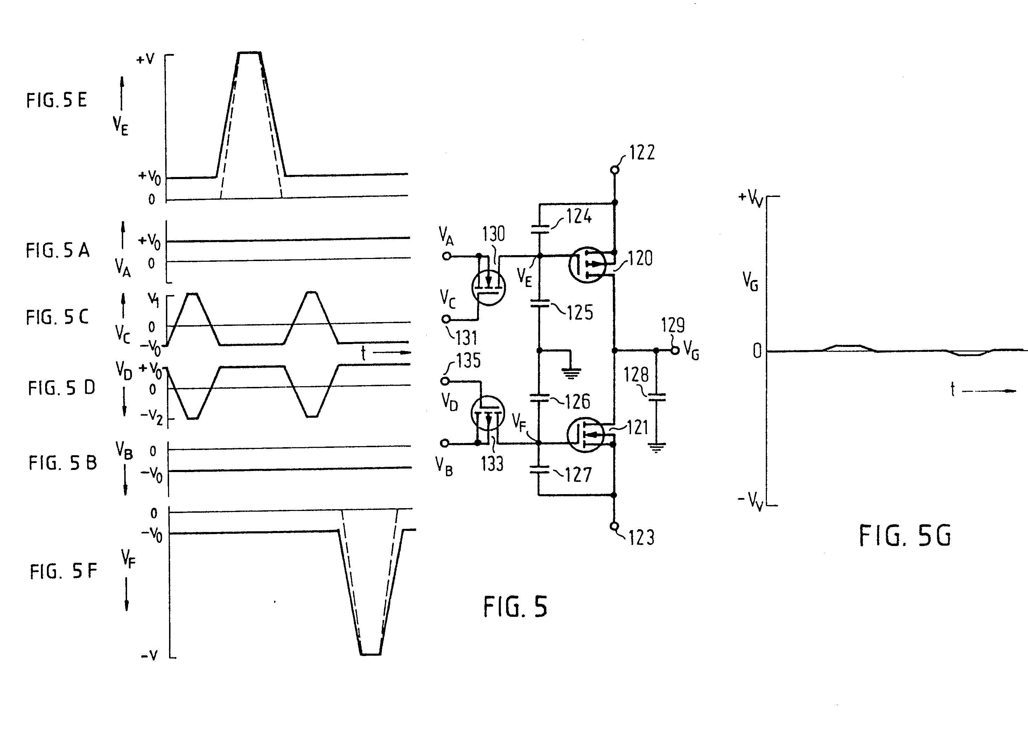

Figur 5 eine der Schaltungsanorndung nach Figur 4 entsprechende Schaltungsanordnung mit eingekoppelten Steuerspannungen, welche so gewählt sind,
daß die zu schaltende Wechselspannung mit
einer Amplitude von nahezu Null geschaltet
wird.

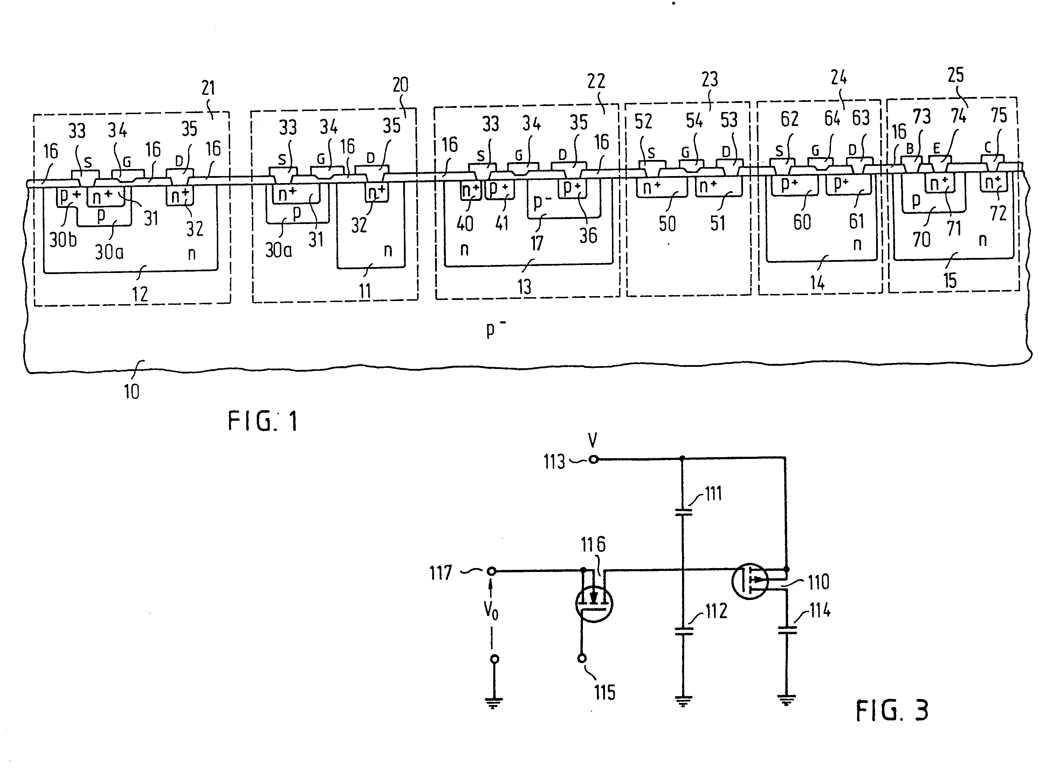

Gemäß Fig. 1 ist ein Hochspannungs-MOS-Transistoren
enthaltender MOS-integrierter Schaltkreis mit einem
Halbleitersubstrat 10 mit niedriger Dotierungskonzentration vorgesehen. Im vorliegenden Ausführungsbeispiel
ist dieses Halbleitersubstrat $p^-$-leitend. In dieses
Halbleitersubstrat 10 sind in einem einzigen Prozeßschritt Zonen 11,12,13,14 und 15 mit gegenüber dem
Halbleitersubstrat 10 entgegengesetztem Leitungstyp
ausgebildet. Im vorliegenden Ausführungsbeispiel sind
diese Zonen 11 bis 15 n-leitend. Die Zonen sind vorzugsweise durch einen Implantationsprozeß und einen Nachdiffusionsprozeß hergestellt.

Ausgehend von dieser Struktur können unterschiedliche Funktionseinheiten mit weiteren, für alle Funktions-einheiten kompatiblen Prozeßschritten hergestellt wer-den.

Für n-Kanal-Hochspannungstransistoren können die genannten Zonen unterschiedliche Abmessungen besitzen, so daß zwei unterschiedliche Typen derartiger Transistoren herstellbar sind. Für einen n-Kanal-Hochspannungstransistor eines Typs, der in Fig. 1 mit 20 bezeichnet ist, besitzt die entsprechende n-Zone 11 eine solche Abmessung, daß sie lediglich die Drain des Transistors allseitig umgibt.

Zur Herstellung eines solchen n-Kanal-Hochspannungstransistors 20 werden nach der an sich bekannten D-MOS-Technologie durch ein einziges Fenster in einer Oxid-Schicht 16 zwei Zonen 30a und 31 in das Substrat eingebracht, die im vorliegenden Ausführungsbeispiel p- bzw. $n^+$-leitend sind. Die Zone 31 bildet mit einem entsprechenden Kontakt 33 die Source des Transistors, während durch den lateralen Bereich der Zone 30a, welcher an die Source-Zone 31 angrenzt, der Kanal des Transistors  gebildet wird, über dem, durch eine Dünnoxidschicht isoliert, eine Gateelektrode 34 vorgesehen ist. Eine in die Zone 11 eindotierte Zone 32, welche im vorliegenden Ausführungsbeispiel $n^+$-leitend ist, bildet zusammen mit einem Kontakt 35 die Drain des Transistors.

Durch das zwischen der Zone 30a und der Zone 11 stehengebliebene Gebiet des Halbleitersubstrats 10 wird in der Zone 11 eine Drift-Zone für den n-Kanal-Hochspannungstransistor 20 gebildet. Die n-Zone 11 wirkt bei dieser Ausführungsform eines n-Kanal-Hochspannungstransistors also als Drift-Zone. Ein Durchbruch des Transistors tritt erst bei höheren Spannungen auf, da die n-Zone 11 gleichzeitig die Eigenschaft eines Pinch-Widerstands hat.

Bei einer weiteren Ausführungsform eines n-Kanal-Hochspannungstransistors, welcher in Fig. 1 mit 21 bezeichnet ist und bei dem gleiche Elemente wie beim Transistor 20 mit gleichen Bezugszeichen versehen sind, besitzt die n-Zone 12 eine solche Abmessung, daß sie den gesamten Transistor allseitig umgibt. Bei diesem Transistor bildet der Bereich der Zone 12 zwischen der den Kanal bildenden p-Zone 30a und der die Drain bildenden Zone 32 die Drift-Zone. Während der Transistor 20 eine höhere Spannungsfestigkeit von $>500$ V besitzt, die etwa doppelt so hoch wie die des Transistors 21 ist, besitzt der Transistor 21 eine höhere Verstärkung. Bei beiden Transistoren ist die erzielbare Leistung (Produkt aus Strom und Spannung) etwa gleich.

Zur Herstellung eines zu den Hochspannungs-MOS-Transistoren 20 und 21 komplementären Hochspannungs-MOS-Transistors, im Ausführungsbeispiel also eines p-Kanal-Hochspannungstransistors, welcher in Fig. 1 mit 22 bezeichnet ist, wird in einer den Transistor allseitig umgebenden n-Zone 13, welche den n-Zonen 11 und 12 entspricht, eine zusätzliche Zone 17 ausgebildet, welche die $p^{+}$-leitende Drainzone 36 allseitig umgibt und gleiche Vorteile verwirklicht wie die bereits beschriebene Zone 11. Diese Zone 17 wird durch einen Dotierungsprozeß mit einer solchen Dotierungskonzentration ausgebildet, daß ihr Leitungstyp dem des Substrats 10 entspricht und daß ihre Dotierung höchstens gleich stark wie die der Zone 13 ist.

Die Source dieses p-Kanal-Hochspannungstransistors 22 wird durch eine $p^+$-Zone 41 gebildet, die durch einen Source-Kontakt 33 kontaktiert ist. Überlappend mit der $p^+$-Zone 41 ist eine $n^+$-Zone 40 vorgesehen. Dadurch ergibt sich eine direkte Verbindung zwischen dem Source-Kontakt 33 und der Zone 13, die verhindert, daß sich zwischen dem Source-Kontakt 33 und der Zone 13 eine Vorspannung aufbaut. Der Kanal dieses Transistors 22 liegt zwischen der Zone 41 und der Zone 17 und ist über eine Dünnoxidschicht mit einem Gate-Kontakt 34 kontaktiert.

Zur Herstellung unterschiedlicher Typen von n-Kanal-Hochspannungstransistoren sowie von p-Kanal-Hochspannungstransistoren ist also lediglich ein einziger Prozeßschritt zur Herstellung der n-Zonen 11,12 und 13 sowie ein zusätzlicher Prozeßschritt zur Herstellung der Zone 17 für den p-Kanal-Hochspannungstransistor 22 und ein Dotier- und Nachdiffusionsschritt für die tiefer reichenden Zonen 30a der n-Kanal-Transistoren 20 und 21 erforderlich. Alle übrigen Zonen können gemeinsam für die Hochspannungstransistoren 20, 21 und 22 in nur einem Prozeßschritt hergestellt werden. So werden die n-Zonen 31, 32 und 40 sowie die p-Zonen 30b,36 und 41 in einem einzigen Prozeßschritt hergestellt.

Das vorstehend beschriebene Verfahren ist weiterhin auch kompatibel mit der Herstellung von n- und p-Kanal-Niederspannungstransistoren sowie von Bipolartransistoren.

Zur Herstellung eines n-Kanal-Niederspannungstransistors, welcher in Fig. 1 mit 23 bezeichnet ist, ist es lediglich erforderlich, zusammen mit der Herstellung der $n^+$-Zonen 31, 32 und 40 für die Hochspannungstransistoren im Halbleitersubstrat 10 zwei $n^+$-Zonen 50 und 51 herzustellen, welche die Source bzw. die Drain dieses Transistors bilden. Die Zonen sind entsprechend mit einem Source-Kontakt 52 und einem Drain-Kontakt 53 sowie mit einem Gate-Kontakt 54 über dem Kanal zwischen den Zonen 50 und 51 kontaktiert.

Zur Herstellung eines p-Kanal-Niederspannungstransistors, welcher in Fig. 1 mit 24 bezeichnet ist, wird zunächst mit den n-leitenden Zonen 11, 12 und 13 für die Hochspannungstransistoren eine entsprechende n-Zone 14 hergestellt. In diese Zone 14 werden zusammen mit den $p^+$-Zonen 30b, 36 und 41 für die Hochspannungstransistoren Source und Drain bildende $p^+$-Zonen 60 und 61 eingebracht, wobei wiederum eine Kontaktierung mit einem Source-Kontakt 62, einem Drain-Kontakt 63 und einem Gate-Kontakt 64 erfolgt.

Zur Herstellung eines Bipolartransistors, welcher in Fig. 1 mit 25 bezeichnet ist, wird in einer mit den Zonen 11 bis 14 zusammen hergestellten n-Zone eine konventionelle Planarstruktur mit einer p-Basis 70, die gleichzeitig mit der Zone 30a des Transistors 20 bzw. 21 oder wahlweise mit der Zone 17 des Transistors 22 gebildet ist und einem $n^+$-Emitter 71, der gleichzeitig mit den Zonen 31, 32, 40 gebildet werden kann, eingebracht. Die n-Zone 15 bildet dabei den Kollektor des Transistors. Eine Kontaktierung erfolgt über einen Basiskontakt 73, einen Emitterkontakt 74 und einen Kollektorkontakt 75. Die $n^+$-Anschlußzone 72 für den Kollektor wird ebenfalls in einem Prozeßschritt zusammen mit allen übrigen $n^+$-Zonen im integrierten Schaltkreis hergestellt.

Im folgenden werden Ausführungsbeispiele für Schaltungsanordnungen zum Schalten von Leistungstransistoren unter Verwendung von insbesondere nach dem vorstehend erläuter-

ten Verfahren hergestellten Hochspannungs-MOS-Transistoren beschrieben.

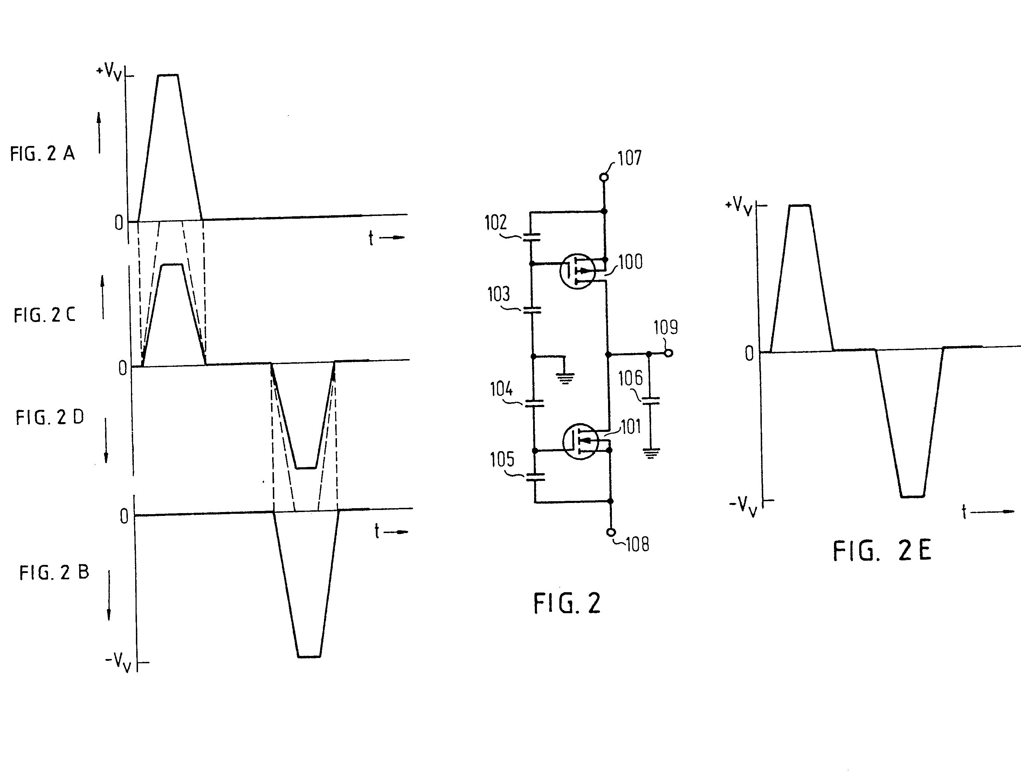

Fig. 2 zeigt eine Ausführungsform zum Schalten von pulsierenden Wechselspannungen mit zwei in Reihe geschalteten komplementären Hochspannungs-MOS-Transostoren 100 und 101. Eine zu schaltende pulsierende Wechselspannung $V_V$ wird an Klemmen 107 und 108 angelegt. An der zu schaltenden Spannung liegt jeweils gegen Masse ein kapazitiver Spannungsteiler 102, 103 bzw. 104, 105, wobei der Abgriff des jeweiligen Spannungsteilers am Gate des Transistors 100 bzw. des Transistors 101 liegt. Am Verbindungspunkt der gesteuerten Strecken der Transistoren 100 und 101 liegt ein Ausgangskondensator 106 als kapazitive Last, wobei an einem Ausgang 109 die Ausgangsspannung erscheint. Anhand von Diagrammen nach den Fig. 2A bis 2E wird die Wirkungsweise der vorstehend beschriebenen Schaltungsanordnung erläutert. Die Diagramme nach Fig. 2A bzw. 2B zeigen als Funktion der Zeit t eine positive bzw. eine negative Halbwelle der an den Klemmen 107 und 108 stehenden zu schaltenden Wechselspannung, welche mit $V_V$ bezeichnet ist. In der positiven Halbwelle der zu schaltenden Wechselspannung laden sich die Kondensatoren 102 und 103 des am Gate des Transistors 100 liegenden kapazitiven Spannungsteilers gemäß dem Spannungsverlauf nach Fig. 2C auf, wobei die Gatespannung am Abgriff dieses Spannungsteilers durch das kapazitive Spannungsteilerverhältnis gegeben ist. Durch diese Gatespannung wird der Transistor 100 entsprechend leitend geschaltet, so daß gemäß Fig. 2E der Ausgangskondensator 106 aufgeladen wird und am Ausgang 109 eine positive Halbwelle der Ausgangsspannung erzeugt wird. Für die negative Halbwelle der zu schaltenden pulsierenden Wechselspannung gemäß Fig. 2B wird entsprechend der kapazitive Spannungsteiler 104, 105 aufgeladen, so daß der Transistor 101 leitend geschaltet wird und damit der Ausgangskondensator 106 auf eine negative Ausgangsspannungs-Halbwelle gemäß Fig. 2E umgeladen wird.

Die Durchschaltung der Transistoren 100 und 101 in der positiven bzw. in der negativen Halbwelle kann durch Wahl der Kapazitätswerte der Kondensatoren in den Spannungsteilern festgelegt werden, so daß die effektive Gatespannung und damit die Leitfähigkeit der Transistoren 100 und 101 beeinflußt werden kann, womit ein gesperrter und ein durchgeschalteter Zustand dieser beiden Transistoren erzeugt werden kann.

Fig. 3 zeigt eine Ausführungsform einer Schaltungsanordnung zum Schalten einer pulsierenden Gleichspannung V. Die Schaltungsanordnung enthält einen Hochspannungs-MOS-Transistor 110, welcher in Reihe mit einem Ausgangskondensator 114 an einer Klemme 113 liegt, an welcher die zu schaltende pulsierende Gleichspannung V eingespeist wird. Weiterhin liegt an der zu schaltenden pulsierenden Gleichspannung an der Klemme 113 ein aus Kondensatoren 111 und 112 gebildeter kapazitiver Spannungsteiler, an dessen Abgriff das Gate des Schalttransistors 110 angeschaltet ist.

In Weiterbildung der Schaltungsanordnung nach Fig. 2, in der das Schaltverhalten der Hochspannungs-MOS-Schalttransistoren lediglich durch das Teilererverhältnis der kapazitiven Spannungsteiler festgelegt wird, ist in der Schaltungsanordnung nach Fig. 3 ein durch an einer Klemme 115 eingespeistes Taktsignal gesteuerter Hochspannungs-MOS-Steuertransistor 116 vorgesehen, über den eine in eine Klemme 117 eingespeiste, mit $V_0$ bezeichnete Steuerspannung in das Gate des Schalttransistors 110 eingespeist wird.

Die Steuerspannung $V_0$ wird vor Einschaltung der zu schaltenden pulsierenden Gleichspannung V durch einen Taktimpuls an der Klemme 115, durch den Steuertransistor 116 durchgeschaltet wird, auf das Gate des Schalttransistors 110 gekoppelt, wodurch eine Vorladung der Kondensatoren 111, 112 erfolgt.

Je nachdem, ob die Steuerspannung $V_0$ negativ oder positiv ist, ergibt sich eine unterschiedliche effektive Gatespannung durch Überlagerung der Steuerspannung und der über den kapazitiven Spannungsteiler aus der zu schaltenden pulsierenden Gleichspannung erzeugten Gatespannung. Durch Wahl der Steuerspannung $V_0$ kann also die effektive Gatespannung erhöht oder erniedrigt und damit das Schaltverhalten des Schalttransistors 110 beeinflußt werden. Der Schalttransistor 110 kann damit sogar vollständig gesperrt gehalten werden.

Die Fig. 4 und 5 zeigen eine Ausführungsform einer Gegentakt-Schaltungsanordnung zum Schalten von pulsierenden Wechselspannungen entsprechend der Ausführungsform nach Fig. 2 mit einer Steuerung durch Steuerspannungen gemäß der Ausführungsform nach Fig. 3.

Die Schaltungsanordnung enthält zwei komplementäre Hochspannungs-MOS-Schalttransistoren 120 und 121, welche in Reihe an einer zu schaltenden pulsierenden Wechselspannung liegen, die an Klemmen 122 und 123 eingespeist wird. An der zu schaltenden pulsierenden Wechselspannung liegt gegen Masse jeweils ein kapazitiver Spannungsteiler 124, 125 bzw. 126, 127, dessen Abgriff jeweils am Gate des Schalttransistors 120 bzw. 121 liegt. Der Verbindungspunkt der gesteuerten Strecken der Schalttransistoren 120 und 121 liegt über einen Ausgangskondensator 128 an Masse, wobei an einem Ausgang 129 eine Ausgangsspannung erscheint.

Über einen Hochspannungs-MOS-Steuertransistor 130 bzw. 133 wird eine Steuerspannung $V_0$ als Funktion von über Klemmen 131 und 135 auf das Gate der Steuertransistoren gegebenen Taktsignalen auf das Gate der Schalttransistoren 120 und 121 gekoppelt.

Diagramme nach den Fig. 4A und 4B zeigen den zeitlichen Verlauf der Steuerspannung $V_0$ für den Schalttransistor 120 (Fig. 4A) und den Schalttransistor 121 (Fig. 4B). Diese Steuerspannungen enthalten pro Periode der zu schaltenden pulsierenden Wechselspannung einen Impuls mit einer solchen Polarität, daß die Durchschaltung der Schalttransistoren 120 und 121 unterstützt wird.

Diagramme nach den Fig. 4C und 4D zeigen den zeitlichen Verlauf der in die Gates der Steuertransistoren 130 und 133 eingespeisten Taktsignale zur Durchschaltung der Steuerspannungen auf die Gates der Schalttransistoren 120 und 121. Pro Periode der zu schaltenden pulsierenden Wechselspannung enthalten die Taktsignale zwei Impulse, durch welche die Steuertransistoren 130 und 133 leitend geschaltet werden. Mit einem Impuls des Taktsignals wird der die Durchschaltung der Schalttransistoren 120 und 121 unterstützende Impuls der Steuerspannungen $V_0$ auf die Gates der Steuertransistoren 120 und 121 gekoppelt. Damit ergibt sich gemäß Diagrammen nach den Fig. 4E und 4F, welche den Verlauf der Gatespannung der Schalttransistoren 120 und 121 zeigen, ein Gatespannungsimpuls großer Amplitude, welcher die Schalttransistoren 120 und 121 durchschaltet und damit gemäß einem
Diagramm nach Fig. 4G die zu schaltende pulsierende
Wechselspannung mit großer Amplitude auf den Ausgang 129
schaltet.

Die die Durchschaltung der Schalttransistoren 120
und 121 unterstützenden Impulse der Steuerspannungen $V_0$
gemäß den Diagrammen nach Fig. 5A und 5B sind auf einen
konstanten Steuerspannungspegel bezogen, durch den die
Schalttransistoren 120 und 121 praktisch gesperrt gehalten werden. Werden diese Spannungen durch den Impuls des Taktsignals innerhalb einer Periode der zu
schaltenden pulsierenden Wechselspannung auf die Gates
der Schalttransistoren 120 und 121 gekoppelt, so bleiben die Schalttransistoren praktisch gesperrt.

Fig. 5 zeigt das Schaltverhalten der Schaltungsanordnung
nach Fig. 4 für konstante Steuerspannungspegel gemäß
den Diagrammen nach den Fig. 5A und 5B. Wie das Diagramm der Ausgangsspannung nach Fig. 5G zeigt, bleiben
die Schalttransistoren 120 und 121 aufgrund der Steuerspannungspegel nach den Fig. 5A und 5B praktisch dauernd
gesperrt, so daß die Ausgangsspannung einen mit praktisch vernachlässigbar kleiner Amplitude um die Abszisse
schwankenden Verlauf zeigt, der durch Einkopplung über
parasitäre Kapazitäten am Ausgang hervorgerufen wird.

Abweichend von den vorstehend beschriebenen Ausführungsbeispielen kann die Schaltungsanordnung auch in Verbindung mit einer induktiven oder ohmschen oder gemischten
Belastung am Ausgang betrieben werden.

Abschließend ist darauf hinzuweisen, daß die erfindungsgemäße Schaltungsanordnung auch mit Hochspannungs-Schalttransistoren vorbekannter Art aufgebaut werden kann.
Vorzugsweise werden für sie aber Schaltkreise der in
Fig. 1 gezeigten Art eingesetzt, da diese, wie gezeigt,
gegenüber herkömmlichen Elementen wesentliche Vorteile,
insbesondere hohe Durchbruchsspannungen, aufweisen, die
im Hinblick auf die mit der Schaltung sehr niedrige
Verlustleistung einen vielseitigen Einsatz gestatten.

Patentansprüche

1. Schaltungsanordnung zum Schalten von Leistungsstromkreisen unter Verwendung von Hochspannungs-MOS-Transistoren, g e k e n n z e i c h n e t   d u r c h einen mit seiner gesteuerten Strecke in Reihe zu einer Ausgangslast (beispielsweise 114) liegenden Hochspannungs-MOS-Schalttransistor (beispielsweise 110), durch eine an der Reihenschaltung aus gesteuerter Strecke des Schalttransistors (beispielsweise 110) und Ausgangslast (beispielsweise 114) liegende zu schaltende pulsierende Spannung (V) und durch einen an dieser Spannung liegenden kapazitiven Spannungsteiler (beispielsweise 111, 112), an dessen Abgriff das Gate des Schalttransistors ( beispielsweise 110) liegt.

2. Schaltungsanordnung nach Anspruch 1, g e k e n n - z e i c h n e t   d u r c h eine Ausbildung als Gegentaktschaltung zum Schalten von Wechsel-Leistungskreisen mit zwei in Reihe an einer zu schaltenden Wechselspannung (V) und jeweils in Reihe zu einer Ausgangslast (106 )liegenden komplementären Hochspannungs-MOS-Schalttransistoren (100, 101) und mit jeweils einem an der zu schaltenden Wechselspannung (V) liegenden kapazitiven Spannungsteiler (102, 103 bzw. 104, 105), an dessen Abgriff jeweils das Gate eines Schalttransistors (100 bzw. 101) liegt.

3. Schaltungsanordnung nach Anspruch 1, g e k e n n - z e i c h n e t   d u r c h einen von einem Taktsignal gesteuerten Hochspannungs-MOS-Steuertransistor (116), über den eine Steuerspannung ($V_0$) als Funktion eines

Taktsignals an das Gate des Schalttransistors (110) koppelbar ist.

4. Schaltungsanordnung nach Anspruch 2, g e k e n n - z e i c h n e t   d u r c h  von Taktsignalen gesteuerte komplementäre Hochspannungs-MOS-Steuertransistoren (130, 133), von denen jeweils einer als Funktion eines jeweiligen Taktsignals jeweils eine Steuerspannung $(V_0)$ an das Gate jeweils eines Schalttransistors (120 bzw. 121) koppelt.

5. Schaltungsanordnung nach einem der Ansprüche 2 bis 4, d a d u r c h   g e k e n n z e i c h n e t , daß die Steuerspannung eine solche Polarität besitzt, daß die effektive Gatespannung des Schalttransistors bzw. der Schalttransistoren (110; 120, 121), welche durch Überlagerung der Steuerspannung und der durch die zu schaltende Spannung über den kapazitiven Spannungsteiler (111, 112 bzw. 124, 125; 126, 127) erzeugten Spannung entsteht, gegenüber der durch die zu schaltende Spannung über den kapazitiven Spannungsteiler (111, 112 bzw. 124, 125; 126, 127) allein erzeugten Gatespannung erniedrigt ist.

6. Schaltungsanordnung nach einem der Ansprüche 2 bis 4, d a d u r c h   g e k e n n z e i c h n e t , daß die Steuerspannung eine solche Polarität besitzt, daß die effektive Gatespannung des Schalttransistors bzw. der Schalttransistoren (110 bzw.120, 121), welche durch Überlagerung der Steuerspannung und der durch die zu schaltende Spannung über den kapazitiven Spannungsteiler (111, 112 bzw. 124, 125; 126, 127) erzeugten Spannung entsteht, gegenüber der durch die zu schaltende Spannung über den kapazitiven Spannungsteiler (111, 112 bzw. 124, 125; 126, 127) allein erzeugten Gatespannung erhöht ist.

FIG. 1

FIG. 3

0080740

FIG. 2 A

FIG. 2 C

FIG. 2 D

FIG. 2 B

FIG. 2

FIG. 2 E

0080740

FIG. 4G

FIG. 4

FIG. 4E — $V_E$

FIG. 4A — $V_A$

FIG. 4C — $V_C$

FIG. 4D — $V_D$

FIG. 4B — $V_B$

FIG. 4F — $V_F$

FIG. 5

FIG. 5G

0080740